# EUROPEAN PATENT SPECIFICATION

(11) **EP 2 523 228 B1**
(45) Date of publication and mention of the grant of the patent: **26.04.2017**
(21) Application number: 11731878.2
(22) Date of filing: 03.01.2011
(51) Int. Cl.: H01L 33/04, H01L 33/02, H01L 33/32, H01L 21/02

(54) **LIGHT EMITTING DIODE**
LICHTEMITTIERENDE DIODE
DIODE ÉLECTROLUMINESCENTE

(30) Priority: 16.11.2010 KR 20100113666; 04.06.2010 KR 20100052861; 04.06.2010 KR 20100052860; 05.01.2010 KR 20100000559
(43) Date of publication of application: 14.11.2012
(73) Proprietor: Seoul Viosys Co., Ltd, Ansan-si, Gyeonggi-do (KR)
(72) Inventor: KIM, Kwang Joong, Ansan-si Gyeonggi-do 425-851 (KR); HAN, Chang Suk, Ansan-si Gyeonggi-do 425-851 (KR); CHOI, Seung Kyu, Ansan-si Gyeonggi-do 425-851 (KR); NAM, Ki Bum, Ansan-si Gyeonggi-do 425-851 (KR); KIM, Nam Yoon, Ansan-si Gyeonggi-do 425-851 (KR); KIM, Kyung Hae, Ansan-si Gyeonggi-do 425-851 (KR); YOON, Ju Hyung, Ansan-si Gyeonggi-do 425-851 (KR); YE, Kyung Hee, Ansan-si Gyeonggi-do 425-851 (KR)
(74) Representative: Isarpatent
(86) International application number: PCT/KR2011/000002
(87) International publication number: WO 2011/083940

(56) References cited:
- JP-A- 2001 274 376
- JP-A- 2001 298 215
- JP-A- 2002 033 509
- KR-A- 20040 029 165
- KR-A- 20080 064 061
- KR-A- 20090 004 493
- KR-A- 20090 034 169
- KR-A- 20090 095 657
- KR-B1- 100 674 862
- KR-B1- 100 835 116
- US-A1- 2005 056 824
- US-A1- 2005 205 881
- US-A1- 2006 192 207
- US-B1- 6 337 493

## Description

### FIELD OF THE INVENTION

The present invention relates to a light emitting diode.

### BACKGROUND OF THE INVENTION

Generally, a gallium nitride-based semiconductor is a light source for a full-color display, a traffic signal lamp, a general lighting, and optical communication devices, which has been prevalently used for an ultraviolet, blue/green light emitting diode, a laser diode, or the like. The gallium nitride-based light emitting device may include an active layer having an InGaN-bascd multi-quantum well structure disposed between n-type and p-type gallium nitride semiconductor layers, and may generate and discharge light by recombination of electrons and holes in the quantum well layer in the active layer.

US 2005/056824 A1 discloses a light emitting diode comprising an n-type contact layer, a p-type contact layer formed on the n-type contact layer, an active region having a multi-quantum well structure and being disposed between the n-type contact layer and the p-type contact layer, and a spacer layer interposed between the n-type contact layer and the active region. The spacer layer is doped with n-type impurities, and the n-type impurity doping concentration is relatively higher than the impurity doping concentration of the n-type contact layer, and the active region is undoped with the n-type impurities. The spacer layer includes an InGaN layer, wherein the content of In of the spacer layer is lower than that within the quantum well layer.

US 6,337,493 B1 discloses a light emitting diode comprising an n-type contact layer doped the silicone, a p-type contact layer, an active region interposed between the n-type contact layer and the p-type contact layer, a superlattice layer interposed between the n-type contact layer and the active region, an undoped intermediate layer interposed between the superlattice layer and the n-type contact layer and an electron reinforcing layer interposed between the undoped intermediate layer and the superlattice layer.

US 2005/205881 A1 discloses a light emitting diode comprising an n-type contact layer, a p-type contact layer formed on the n-type contact layer, an active region having a multi-quantum well structure and interposed between the n-type contact layer and the p-type contact layer, and a spacer layer interposed between the n-type contact layer and the active region, wherein the spacer layer is doped with n-type impurities, and the active region is undoped with the n-type impurities.

US 2006/0192207 A1 discloses a light emitting diode comprising an n-side contact layer formed on a substrate, a current diffusion layer formed on the n-side contact layer, an active layer formed on the current fusion layer and p-type clad layer formed on the active layer. The current diffusion layer is formed by alternately stacking at least one first InAlGaN layer having a higher electron concentration than that of the n-side contact layer and at least one InAlGaN layer having a lower electron concentration than that of the n-side contact layer.

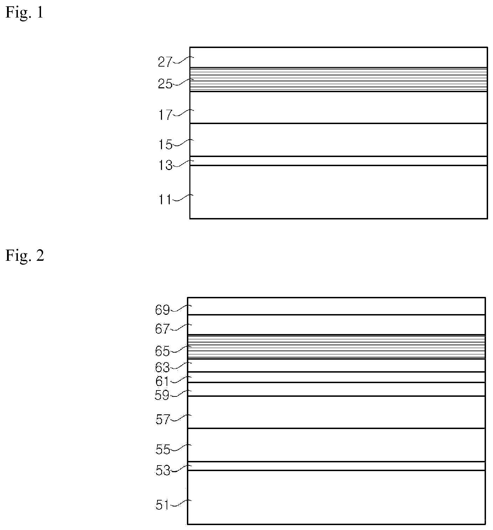

FIG. 1 is a cross-sectional view for explaining a light emitting diode according to an illustrative example.

Referring to FIG. 1, the light emitting diode includes a substrate 11, a low-temperature buffer layer or nuclear layer 13, an undoped GaN layer 15, an n-type contact layer 17, an active region 25, and a p type contact layer 27.

The light emitting diode according to the related art includes the active region 25 having the multi-quantum well structure disposed between the n-type contact layer 17 and the p-type contact layer 27, thereby making it possible to improve luminous efficiency. Further, the light emitting diode controls an In content of an InGaN well layer within the multi-quantum well structure, thereby making it possible to emit light of a desired wavelength.

The n-type contact layer 17 generally has a doping concentration within the range of 1 × 10¹⁸/cm³ ∼ 1 × 10¹⁹/cm³ and serves to supply electrons in the light emitting diode. The current spreading performance within the light emitting diode has a large effect on the luminous efficiency of the light emitting diode. When the n-type contact layer 17 and the p-type contact layer 27 are respectively provided with an n-electrode and a p-electrode (not shown), current concentration may occur according to a size of an area and a position in which the n-electrode and p-electrode may contact the contact layers 17 and 27. When high voltage such as electrostatic discharge is applied to the light emitting diode, the light emitting diode may be easily broken due to the current concentration. In addition, thread dislocations generated from the low-temperature buffer layer 13 are transferred to the undoped GaN layer 15, the n-type contact layer 17, the active region 25, and the p-type contact layer 27. Since current intensively flows through these thread dislocations, the electrostatic discharge characteristics are further deteriorated.

In addition, since there is about 11% of lattice mismatch between the GaN and the InN, a strong strain occurs at an interface between a quantum well and a quantum barrier in the InGaN-based multi-quantum well structure. The strain causes a piezoelectric field in the quantum well, thereby leading to the degradation of internal quantum efficiency. In particular, in the case of the green light emitting diode, since the amount of In contained in the quantum well is increased, the internal quantum efficiency is further reduced by the piezoelectric field.

In the InGaN light emitting diode, the active region having the multi-quantum well structure is generally formed by alternately stacking the InGaN well layer and the InGaN barrier layer. The well layer is formed of a semiconductor layer having a smaller bandgap than that of the barrier layer and electrons and holes are recombined between the well layer. In addition, the barrier layers may be doped with Si in order to lower a driving voltage Vf.

However, the Si doping may have a negative effect on the crystal quality of the active region. Further, due to the limitations of epitaxial growth technology, there is a problem in that the active region having the multi-quantum well structure is relatively thick according to the doping of Si. In particular, when Si is doped in the active region including In, crystal defects frequently occur on the surface of the active region and in the active region and a wavelength shift is easily generated due to a space charge separation generated by a polarized field.

Meanwhile, it is found that the external quantum efficiency is increased with the increase in injection current under low current, while the external quantum efficiency is degraded with the increase in injection current under the high current. This phenomenon is referred to as an efficiency droop, which limits the high efficiency of the high-output light emitting diode.

As factors causing the efficiency droop, there are thermal vibration, Auger recombination, internal field within the multi-quantum well structure, non-recombination field due to the crystal structure, etc.

Electrons and holes do not stay long in the active layer region due to the thermal vibration according to thermal or Joule heating, thereby making it possible to cause the efficiency droop. The efficiency droop may be caused by the occurrence of the Auger recombination due to the increase in carrier concentration when high current is injected. Further, the efficiency degradation may be caused with the increase in non-recombination due to electron overflow during the application of high voltage and the efficiency droop may be caused with the nonraditive-recombination rate due to the defects in a semiconductor crystal.

Meanwhile, an AlGaN electron blocking layer (EBL) may be formed on the active
layer in order to prevent electrons from being discharged out the active layer. However, the internal field may be generated in the active layer and the electron blocking layer by spontaneous polarization and piezo polarization. Due to the internal field within the active layer and the electron blocking layer, the high voltage should be applied in order to pass electrons through the active layer having the multi-quantum well structure. In particular, if the applied voltage is larger than a built-in voltage in the high-output diode of 350 mA, a conduction band at an n side has a higher energy level than a conduction band at a p side, based on the center of the active layer and the energy level of the electron blocking layer is lowered, thereby increasing a leakage current. In order to increase the energy level of the electron blocking layer, A1 composition may increase within the electron blocking layer, which degrades the crystal quality.

### SUMMARY OF THE INVENTION

An object of the present invention is to provide a light emitting diode with improved electrostatic discharge characteristics.

Another object of the present invention is to provide a light emitting diode with low current leakage.

Another object of the present invention is to provide a method for manufacturing a light emitting diode with improved current spreading performance.

Another object of the present invention is to provide a light emitting diode capable of lowering a driving voltage by reducing the generation of internal field.

Another object of the present invention is to provide a light emitting diode capable of reducing efficiency droop.

According to the present invention, there is provided a light emitting diode, as defined in independent claim 1.

The active region has a multi-quantum well structure including an InGaN layer.

The spacer layer includes an InGaN layer, and may be formed by alternately stacking Inₓ Ga₁₋ₓ N (0≤x<1) and In_{y} Ga_{1-y} N (0≤y<1). The spacer layer may include mutually alternately stacked superlattice layers.

The spacer layer may be configured of a plurality of layers, at least one layer adjacent to the active region of the plurality of layers being doped with n-type impurities, remaining layers thereof being undoped with the n-type impurities, and the n-type impurity doping concentration being relatively higher than the impurity doping concentration of the n-type contact layer.

The light emitting diode includes an intermediate layer formed between the spacer layer and the n-type contact layer, wherein the intermediate layer includes a layer doped with the n-type impurities at a concentration relatively higher than the impurity doping concentration of the n-type contact layer and relatively lower than the n-type impurity doping concentration of the spacer layer.

The intermediate layer includes an n-type AlGaN layer. The n-type AlGaN layer has gradually or stepwise reduced Al composition toward the active region. The n-type AlGaN layer may be formed in a multilayer film structure of AlGaN/GaN or AlGaN/InGaN. The intermediate layer may further include an n-GaN layer between the spacer layer and the n-type AlGaN layer. The intermediate layer may include at least one of an undoped GaN layer and a low-doped n-GaN layer between the n-type AlGaN layer and the n-type contact layer.

The light emitting diode may further include a p-type clad layer formed between the active region and the p-type contact layer. The p-type clad layer may include a p-type AlGaN layer. The p-type AlGaN layer may be formed in a multilayer film structure of AlGaN/GaN or AlGaN/InGaN. A layer adjacent to the active region of the p-type AlGaN layers may be made of AlGaN. The AlGaN layer adjacent to the active region of the p-type AlGaN layers may be thinner than other layers within the p-type clad layer. The p-type AlGaN may have gradually or stepwise reduced Al composition toward the p-type contact layer.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.
FIG. 1 is a cross-sectional view for explaining a light emitting diode according to an illustrative example;
FIG. 2 is a cross-sectional view for explaining a light emitting diode according to an illustrative example;
FIG. 3 is a schematic diagram for explaining a silicon doping profile of the light emitting diode according to Fig. 2;
FIG. 4 is a cross-sectional view for explaining a light emitting diode according to another illustrative example;
FIG. 5 is a schematic temperature profile for explaining a method for manufacturing a light emitting diode according to the illustrative example;
FIGS. 6, 7, and 8 each are cross-sectional views for explaining a light emitting diode according to another exemplary illustrative example and show a silicon doping profile and a spacer layer structure;
FIGS. 9 and 10 each are cross-sectional views for explaining a light emitting diode according to an exemplary embodiment of the present invention and show a silicon doping profile;
FIG. 11 is a cross-sectional view for explaining a light emitting diode according to another exemplary embodiment of the present invention;
FIG. 12 is a cross-sectional view for explaining a light emitting diode according to another exemplary embodiment of the present invention; and
FIG. 13 is a cross-sectional view for explaining a light emitting diode according to another exemplary embodiment of the present invention.

### DETAILED DESCRIPTION OF THE ILLUSTRATED EMBODIMENTS

The invention is described more fully hereinafter with reference to the accompanying drawings, in which exemplary embodiments of the invention are shown. This invention may, however, be embodied in many different forms and should not be construed as limited to the exemplary embodiments set forth herein. Rather, these exemplary embodiments are provided so that this disclosure is thorough, and will fully convey the scope of the invention to those skilled in the art. In the drawings, the size and relative sizes of layers and regions may be exaggerated for clarity. Like reference numerals in the drawings denote like elements.

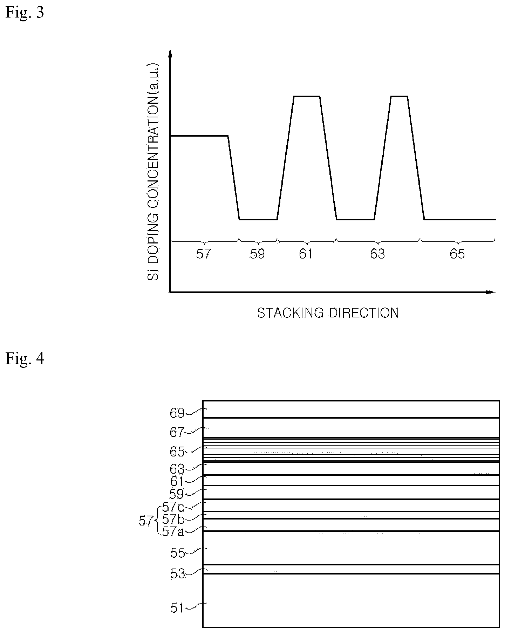

FIG. 2 is a cross-sectional view for explaining a light emitting diode according to an illustrative example and FIG. 3 shows a
schematic silicon doping profile of the light emitting diode.

Referring to FIGS. 2 and 3, the light emitting diode is configured to include an n-type contact layer 57, an undoped intermediate layer 59, an electron reinforcing layer 61, a superlattice layer 63, an active region 65, and a p-type contact layer 69. Further, the light emitting diode may include a substrate 51, a low-temperature buffer layer or nuclear layer 53, a buffer layer 55, and a p-type clad layer 67.

The substrate 51 is a substrate for growing a gallium nitride-based semiconductor layer. The substrate may be made of sapphire, SiC, spinel, or the like, but is not specifically limited. For example, the substrate may be a patterned sapphire substrate (PSS).

The nuclear layer 53 may be formed of (Al, Ga) N at a low temperature of 400 to 600 in order to grow the buffer layer 55 on the substrate 51. Preferably, the nuclear layer 53 may be made of GaN or AlN. The nuclear layer may be formed to have a thickness of about 25 nm. The buffer layer 55, which is a layer to reduce the defect occurrence such as dislocations between the substrate 51 and the n-type contact layer 57, is grown at a relatively high temperature. The buffer layer 55 may be made of, for example, the undoped GaN.

The n-type contact layer 57 is formed of an n-type impurity, for example, Si-doped gallium nitride semiconductor layer. The n-type contact layer 57 may include a GaN layer and may be formed of a single layer or a multi-layer. As shown in FIG. 4, the n-type contact layer 57 may be configured to include an n-type first GaN layer 57a, an n-type AlGaN layer 57b, and an n-type second GaN layer 57c. That is, the AlGaN layer 57b is interposed between the GaN layers 57a and 57c. An Si doping concentration doped on the n-type contact layer may be in the range of 1 × 10¹⁸/cm³ ∼ 1 × 10¹⁹/cm³.

For example, as shown in FIG. 4, when the first n-type GaN layer 57a is grown and then, the n-type AlGaN layer 57b is grown, the biaxial stress occurs by the n-type AlGaN layer 57b. In addition, when the second n-type GaN layer 57c is grown again, the biaxial stress is reduced by the compression stress, thereby making it possible to reduce the thread dislocations due to the change in stress. Therefore, it is possible to prevent the thread dislocations transferred through the nuclear layer 53 and the high-temperature buffer layer 55 from being transferred to the active region 65 by disposing the n-type AlGaN layer 57b between the n-type GaN layers 57a and 57c.

The undoped intermediate layer 59 may be made of the GaN, which is not intentionally doped with impurities, to have a thickness of 10.0 to 500.0 nm. Since the undoped intermediate layer 59 is not doped with impurities, it has relatively higher specific resistance as compared to the n-type contact layer. Therefore, electrons introduced into the active layer 65 from the n-type contact layer 57 may be uniformly spread within the n-type contact layer 57 before passing through the undoped intermediate layer 59.

The electron reinforcing layer 61 is formed on the undoped intermediate layer 59. The electron reinforcing layer 61 may be made of the GaN doped with Si at high concentration to have a thickness of 1.0 to 200.0 nm, thereby making it possible to lower the forward voltage of the light emitting diode. As shown in FIG. 3, the doping concentration of Si doped on the electron reinforcing layer 61 is higher than the silicon doping concentration of the n-type contact layer 57. The silicon doping concentration within the electron reinforcing layer 61 may be four times or higher than the silicon doping concentration of the n-type contact layer 57.

The n-type contact layer 57, the undoped intermediate layer 59, and the electron reinforcing layer 61 may be continuously grown by supplying the metal source gas to the chamber. As a raw material of the metal source gas, organic matters such as Al, Ga, and In, for example, TMA, TMG, and/or TMI, or the like, are used. These layers may be grown at a first temperature, for example, at 1050 ∼ 1150°C.

The superlattice layer 63 is formed on the electron reinforcing layer 61. The superlattice layer 63 may be formed by alternately stacking the GaN layer and the InGaN layer at a thickness of, for example, 20 . A first layer of the superlattice layer 63 may be made of GaN or InGaN, but the final layer may be made of GaN. The final layer of the superlattice layer 63 is doped with high-concentration Si. The doping concentration of Si doped on the final layer may be about four times to five times higher than the concentration of Si doped on the n-type contact layer 57. The Si concentration doped on the final layer of the superlattice layer 63 may be approximately the same as the doping concentration of the electron reinforcing layer 61. Therefore, the final layer of the superlattice layer 63 and the electron reinforcing layer 61 below the superlattice layer 63 are formed of a high-concentration doped layer and the remaining layers of the superlattice layer 63 positioned therebetween is formed of the undoped layer.

Most layers of the superlattice layer 63 are formed of the undoped layer, thereby making it possible to reduce the leakage current of the light emitting diode. Further, the final layer of the superlattice layer 63 is doped at high concentration, thereby making it possible to improve junction characteristics between the superlattice layer 63 and the active region 65.

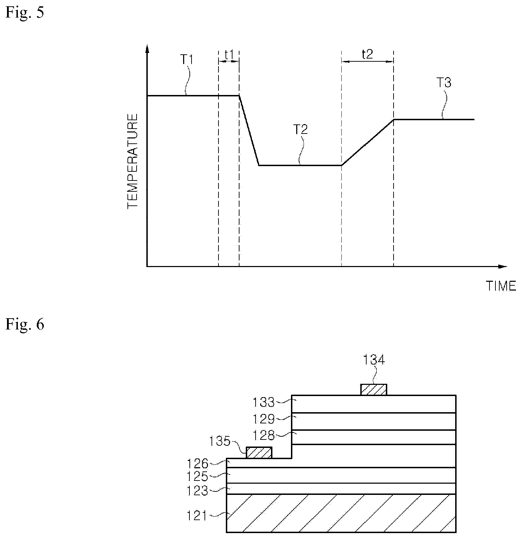

Meanwhile, the superlattice layer 63 may be grown at a relatively lower temperature that the electron reinforcing layer 61. As shown in FIG. 5, before the superlattice layer 63 is grown, the electron reinforcing layer 61 is grown and then, the supply of metal source gas stops, and the grown electron reinforcing layer 61 is maintained on the substrate 21 of a first temperature T1 for a first time t1. The first time t1 may be a time of sufficiently discharge the metal source gas remaining in the chamber, that is, about 3 to 10 minutes, preferably, about 5 to 7 minutes. In addition, for the first time t1, the n-type contact layer 57 and the intermediate layer 59 have been heat-treated, including the electron reinforcing layer 61, thereby improving the crystal quality of the n-side semiconductor layer.

Then, the temperature of the substrate 21 falls from the first temperature T1 to a second temperature T2. The second temperature T2 is set to a temperature suitable to grow the superlattice layer 63. The second temperature T2 may be in the range of, for example, 650 to 800 .

After the growth of the superlattice layer 63 is completed, the active region 65 is grown on the superlattice layer 63. The active region 65 may be grown at the same temperature as the superlattice layer 63 or relatively lower temperature than the superlattice layer 63, for example, 650 to 750 . For simplification, FIG. 5 shows the case in which the active region 65 is grown at the growth temperature of the superlattice layer 63, i.e., the second temperature T2.

The active region 65 may have the multi-quantum well structure in which the barrier layer and the InGaN quantum well layer are alternately stacked. The barrier layer may be formed of the gallium nitride semiconductor layer having a wider bandgap than that of the quantum well layer, for example, GaN, InGaN, AlGaN, or AlInGaN. The In composition ratio within the InGaN quantum well layer is determined by the desired optical wavelength. The active region 65 may contact the final layer of the superlattice layer 63. The barrier layer and the quantum well layer of the active region 65 may be formed of the undoped layer in which impurities are not doped, in order to improve the crystal quality of the active region or may be doped with impurities within some or entire active region in order to lower forward voltage.

A p-type contact layer 69 is disposed on the active region 65 and a p-type clad layer 67 may be interposed between the active region 65 and the p-type contact layer 69. For example, after the grown of the active region 65 is completed, the supply of metal source gas stops and the temperature of the substrate 51 rises to a third temperature T3 for the second time t2. The second time t2 is set to a time in which the metal source gas remaining in the chamber can be sufficiently discharged. For example, the second time t2 may be in the range of 5 to 15 minutes. Alternatively, after the growth of the active region 65 is completed, the supply of metal source gas may stop and the temperature of the substrate 51 may be maintained at the active region growth temperature for the third time, for example, at the second temperature T2 for a third time. The third time may be, for example, in the range of the same time as the first time, i.e., 3 to 10 minutes. After the growth of the active region 65 is completed, a unit maintaining the temperature at the second temperature for the third time and a unit increasing the temperature from the second temperature to the third temperature for the second time t2 may be used an alternative unit to each other, but is not limited thereto. These units may be

Then, the metal source gas is supplied into the chamber and the p-side gallium nitride-based semiconductor layer, for example, the p-type clad layer 67 or the p-type contact layer 69 are grown, at the third temperature T3. The p-type clad layer 67 may be AlGaN. In addition, the p-type gallium nitride-based semiconductor layer 69 may be a multi-layer structure including a single layer or a GaN layer.

After the growth of the epitaxial layers of the light emitting diode is completed, the individual light emitting diode chips are manufactured by using the epitaxial layers.

### (Experimental Example 1)

The epitaxial layer having the above-mentioned structure was grown with reference to FIGS. 2 and 3 by using a MOCVD device. In this case, all the other conditions were the same and the Si doping position was different at the GaN/InGaN superlattice layer. The n-type GaN contact layer 57, the undoped GaN intermediate layer 59, the high-concentration doped GaN electron reinforcing layer 61 were sequentially grown on the undoped GaN buffer layer 55, the superlattice layer was grown on the electron reinforcing layer 61, and the active region 65 having the multi-quantum well structure, the p-type AlGaN clad layer 67, and the p-type GaN contact layer 69 were sequentially grown on the superlattice layer.

Comparative Example doped Si on all the GaN layers in the superlattice layer and Example doped only the final layer of the superlattice, i.e., the GaN layer with Si at the same high concentration as the electron reinforcing layer 61. The grown epitaxial layer was separated, together with the substrate and measures the optical characteristics and the electrical characteristics. The results were listed in Table 1. In this configuration, the electrostatic discharge (ESD) characteristics used the reverse voltage of 1000 V to perform the electrostatic discharge test on the good light emitting diodes manufactured on the same wafer to confirm the occurrence of defects, which are represented by the ESD pass ratio. In the optical output and the electrical characteristic values, the values measured before the ESD test was performed were represented by percentage based on Comparative Example.

**Table 1**

| | ESD Pass Ratio | Peak Wavelength (nm) | Forward Voltage (Vf) | Optical Output | Leakage Current @-5V | Reverse Voltage (Vr)@10µA |
|---|---|---|---|---|---|---|
| Comparative Example | 0% | 456.6 | 100 | 100 | 100 | 100 |
| Example | 92% | 451.5 | 100.6 | 97.4 | 11.61 | 118.6 |

Referring to Table 1, Inventive Example and Comparative Example according to the present invention slightly reduced the peak wavelength and slightly increased the forward voltage, so that the optical output was slightly reduced but the large difference was not shown. However, Example shown the case in which the leakage current was suddenly reduced ax compared to Comparative Example, thereby very improving the ESD characteristics.

### (Experimental Example 2)

The epitaxial layer having a structure according to Example of FIG. 4 was grown by the MOCVD device. In this case, all the other conditions were the same. The case (Comparative Example) in which the n-type contact layer was formed only the n-type GaN was compared with the case (Example) in which the n-type AlGaN layer was interposed between the n-type GaN layers.

The grown epitaxial layer was separated, together with the substrate and measured the optical characteristics and the electrical characteristics. The results were listed in Table 2. in this configuration, the electrostatic discharge (ESD) characteristics used the reverse voltage of 1000 V to perform the electrostatic discharge test on the good light emitting diodes manufactured on the same wafer to confirm the occurrence of defects, which were represented by the ESD pass ratio. The optical output and the leakage current were subjected to the ESD test and then, the values measured in the good light emitting diodes were represented by percentage, based on Comparative Example.

**Table 2**

| | ESD Pass Ratio | Peak Wavelength (nm) | Optical Output | Leakage Current @-5V |
|---|---|---|---|---|
| Comparative Example | 69.34% | 454.0 | 100 | 100 |
| Example | 87.68% | 453.64 | 98.9 | 100 |

Referring to Table 2, Example according to the illustrative example shown the case in which the peak wavelength was slightly reduced and the optical output was slightly reduced, as compared to Comparative Example. However, Example shown the significantly improved ESD characteristics as compared to Comparative Example and the leakage current of the light emitting diodes passing through the ESD has no difference between Comparative Example and Example.

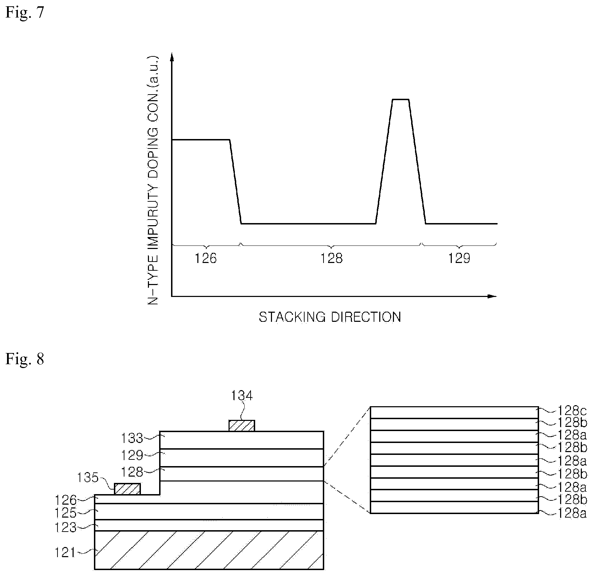

FIG. 6 is a cross-sectional view for explaining a light emitting diode according to anillustrative example, FIG. 7 shows a schematic silicon doping profile of the light emitting diode, and FIG. 8 shows a spacer layer structure of the light emitting diode.

Referring to FIGS. 6 to 8, the light emitting diode includes a substrate 121, an n-type contact layer 126, a spacer layer 128, an active region 129 having a multi-quantum well structure, and a p-type contact layer 133. In addition, a nuclear layer 123 and an undoped GaN layer 125 (u-GaN) may be interposed between the substrate 121 and the n-type contact layer 126.
The substrate 121 is a substrate to grow the gallium nitride-based semiconductor layer. The substrate may be made of sapphire, SiC, spinel, or the like, but is not specifically limited. For example, the substrate may be a patterned sapphire substrate (PSS).

The nuclear layer 123 may be made of (Al, Ga)N at a low temperature of 400 to 600°C in order to grow the u-GaN 125 on the substrate 121, preferably, AlN. The nuclear layer may be formed of a thickness of about 25 nm.

The u-GaN layer 125 is a layer to reduce the occurrence of defects such as dislocations between the substrate 121 and the n-type contact layer 126 and is grown at relatively high temperature, for example, 900 to 1200°C.

The n-type contact layer 126 is a layer on which the n-electrode 139 is formed and may be doped with n-type impurities such as Si or Ge. For example, the impurity concentration of the n-type contact layer 126 may be, for example, 5 × 10¹⁸ atm/cm³ and may be an n-GaN grown at relatively high temperature, a first temperature T1, for example, 2 or less at 900 to 1200°C.

The spacer layer 128 may be made of a (Al, In, Ga) N-based III group nitride semiconductor layer having a smaller bandgap than that of the barrier layer of the active region 129 and a larger bandgap than that of the well layer. For example, the spacer layer 128 may include Inₓ Ga₁₋ₓ N (0≤x<1).

The spacer layer 128 is doped with an n-type impurity at high concentration, thereby lowering the forward voltage of the light emitting diode. As shown in FIG. 7, the doping concentration of the n-type impurity doped on the spacer layer 128 is higher than the n-type impurity doping concentration of the n-type contact layer 126.

The In composition ratio of the spacer layer 128 may be smaller than the In composition ratio within the InGaN quantum well layer. In this case, it can confine charges in the active region well, thereby making it possible to improve the luminous efficiency.

In this case, the n-type impurity is doped in some thickness regions adjacent to the active region 129 based on the growth direction of the spacer layer 128. The remaining thickness regions other than thickness regions doped with the n-type impurity undope the n-type impurity. Only some thickness region adjacent to the active region 129 among the entire thickness regions of the spacer layer 128 is doped with the n-type impurity, so that electrons can be smoothly injected from the spacer layer 128 to the active region 129. In addition, the doping concentration in the area in which the n-type impurity is doped may be relatively higher than the impurity doping concentration of the n-type contact layer 126, for example, 9×10¹⁹ atm/cm³. Therefore, the resistance increase of the spacer layer 128 can be prevented and the electron injection efficiency into the active region 129 can be increased due to electrons generated in the spacer layer. Meanwhile, as shown in FIG. 8, the spacer layer 128 may have a structure in which (Al, In, Ga)N-based III group nitride semiconductor layers 128a and 128b having a smaller bandgap than that of the barrier layer of the active region 129 and a larger bandgap than that of the well layer are alternately stacked. For example, the spacer layer 128 may be made by alternately stacking InₓGal₁₋ₓN (0<x<1)128a and In_{y}Ga_{1-y}N (0≤y<1)128b having different compositions. The InₓGal₁₋ₓN (0≤x<1)28a may be formed at, for example, a thickness of 30 to 40 and the In_{y}Ga_{1-y}N (0≤y<1)28b may be formed at a thickness of 15 to 20 .

The spacer layers 128 having a stacked structure of InₓGal₁₋ₓN (0≤x<1) 128a and In_{y}Ga_{1-y}N (0≤y<1) 128b may improve the crystallinity of the active region 129 formed thereon and reduce strain. The spacer layers 128 may be formed at seven to fifteen periods. When it is below 7 periods, the spacer layers 128 are weak in terms of an effect of alleviating the strain generated in the active region, and when it exceeds 15 periods, process time is increased.

At this time, at least one layer 128a and 128b adjacent to the active region 129 in the spacer layers 128 are doped with n-type impurities. The remaining layers other than the layers doped with the n-type impurities are undoped with the n-type impurities. Only an InGaN layer 128a and/or an InGaN layer 128b adjacent to the active region 129 of the spacer layers 128 are doped with the n-type impurities, thereby making it possible to smoothly inject electrons from the spacer layers 128 into the active region 129. In addition, the doping concentration of the InGaN layer 128a doped with the n-type impurities may be, for example, 9×10¹⁹ atm/cm³, which is relatively higher than the impurity doping concentration of the n-type contact layer 126. Accordingly, the increase in resistance of the spacer layers 128 may be prevented, and the efficiency of injection of the electrons into the active region may be increased by the electron created in the spacer layers 128.

Most layers of the spacer layers 128 are formed as undoped layers, thereby making it possible to reduce leakage current of the light emitting diode. In addition, the at least one layer 128a and 128b adjacent to the active region 129 are doped with the n-type impurities at a high concentration, thereby making it possible to improve junction characteristics between the spacer layer 128 and the active region 129.

Meanwhile, the spacer layer 128c adjacent to the active region 129 may be an InGaN layer further including In as compared to other semiconductor layers configuring the spacer layer 128. At this time, the amount of In included in the spacer layer 128c adjacent to the active region 129 may be higher than that in the quantum well layer. In this case, the n-type impurities are doped at about doping concentration of the n-type contact layer, and may be preferably doped toward the n-type contact layer 126 within the spacer layer 128c.

The active region 129 has a multi-quantum well structure in which a barrier layer and a quantum well layer are alternately stacked, wherein the quantum well layer includes an InGaN layer. The quantum barrier layer may be made of a gallium nitride based semiconductor layer having a bandgap wider than that of the quantum well layer, for example, GaN, InGaN, AlGaN, or AlInGaN. An In composition ratio within the InGaN quantum well layer is determined by a desired optical wavelength. The active region 129 is undoped with the n-type impurities, for example, Si or Ge.

A p-type contact layer 133 is disposed on the active region 129. The p-type contact layer 133 may be made of, for example, GaN on the active region 129.

In addition, a transparent electrode (not shown) such as Ni/Au or indium tin oxide (ITO) is formed on the p-type contact layer 133, and a p-electrode 134 may be formed thereon using a liftoff process. Further, an n-electrode 135 such as Ti/Al, etc., may be formed on the n-type contact layer 126 using the liftoff process.

In the exemplary embodiments as described above, the active region 129 has the quantum barrier layer and the quantum well layer undoped with the n-type impurities and is grown on the spacer layer 128 having the stacked structure of InₓGal₁₋ₓN (0≤x<1) 128a and In_{y}Ga_{1-y}N (0≤y<1) 128b mostly not including the n-type impurities, thereby making it possible to improve the crystallinity of the active region 129 and reduce the strain. In addition, only the InGaN layer 128a and/or the InGaN layer 128b adjacent to the active region 129 of the spacer layers 128 are doped with the n-type impurities to smoothly inject electrons from the spacer layer 128 into the active region 129, thereby making it possible to increase a recombination ratio of carriers in the active region 129. As a result, it is possible to improve light emitting efficiency of the light emitting diode.

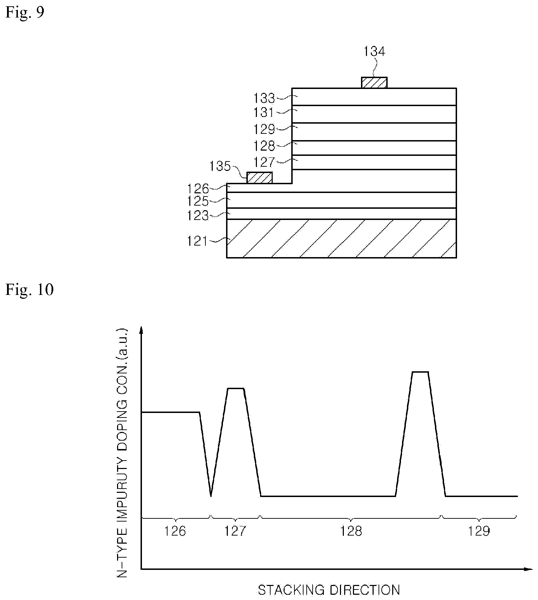

FIGS. 9 and 10 each are cross-sectional views for explaining a light emitting diode according to another exemplary embodiment of the present invention and show a silicon doping profile.

Referring to FIGS. 9 and 10, a light emitting diode according to the present embodiment has the almost same stacked structure as that of the light emitting diode described with reference to FIGS. 6 to 8; however, it further includes an intermediate layer 127 doped with n-type impurities between the spacer layer 128 and the n-type contact layer 126 and a p-type clad layer 131 interposed between the active region 129 and the p-type contact layer 133.

The intermediate layer 127 is doped with the n-type impurities at, for example, a concentration of 2.5×10¹⁹ atm/cm³, which is relatively higher than the impurity doping concentration of the n-type contact layer 126 and is relative lower than the n-type impurity doping concentration of the spacer layer 128, and may include an n-AlGaN layer, as shown in FIG. 10.

The n-AlGaN layer may have gradually or stepwise reduced Al composition toward the active region 129. At this time, Al has a composition range of 10 to 15% and is stacked at a thickness of 10 to 100nm, preferably, 30 to 60nm. The Al composition is gradually or stepwise reduced within the n-AlGaN layer, such that the intermediate layer 127 has a gradually reduced energy level toward the active region 129. Therefore, the intermediate layer 127 may have the lowest energy level at the interface between the intermediate layer 127 and the spacer layer 128.

In addition, the n-AlGaN layer may be formed in a multi-layer film structure. For example, n-AlGaN layer may be configured of a multi-layer film of AlGaN/GaN or AlGaN/InGaN. When the n-AlGaN layer is configured of the multi-layer film, it is to improve the crystallinity of the AlGaN layer. For example, the n-AlGaN layer may have gradually or stepwise reduced Al composition toward the active region 129.

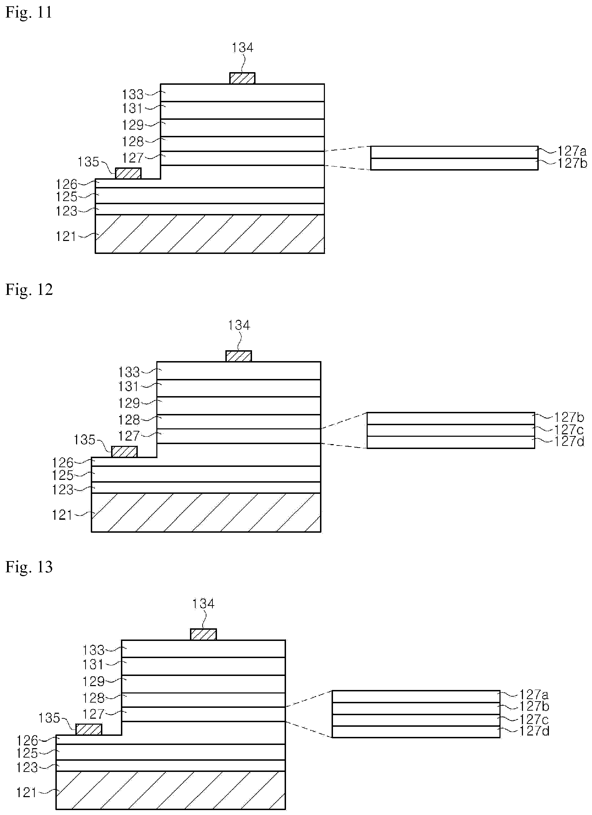

Meanwhile, the intermediate layer 127 may include an n-GaN 27a stacked between an n-AlGaN layer 127b and a spacer layer 128 at a thickness of 200 to 300nm, as shown in FIG. 11.

In addition, the intermediate layer 127 may include an undoped GaN layer 127c and a low-doped n-GaN layer 127d, and be stacked between the n-AlGaN layer 127b and the n-type contact layer 126 at a thickness of 100.0 to 200.0nm, as shown in FIG. 12. FIG. 12 shows a case in which the undoped GaN layer 127c is formed on the low-doped n-GaN layer 127d; however, the present invention is not limited thereto but the n-GaN layer 127d may be formed on the undoped GaN layer 127c, as needed. In addition, only any one of the undoped GaN layer 127c and the low-doped n-GaN layer 127d may be formed.

In addition, the intermediate layer 127 may include the n-GaN layer 127a, the n-AlGaN layer 127b, the undoped GaN layer 127c, and the low-doped n-GaN layer 127d between the spacer layer 128 and the n-type contact layer 126, as shown in FIG. 13. The undoped GaN layer 127c may be made of GaN, which is not intentionally doped with impurities, to have a thickness of 10.0 to 500.0nm. Since the undoped GaN layer 127c is not doped with impurities, it has relatively higher specific resistance as compared to the n-type contact layer 126. Therefore, electrons introduced into the active layer 129 from the n-type contact layer 126 may be uniformly spread within the n-type contact layer 126 before passing through the undoped GaN layer 127c.

Since the low-doped n-GaN layer 127d is doped with impurities at a lower concentration as compared to the n-type contact layer 126, it has relatively higher specific resistance as compared to the n-type contact layer 126. Therefore, electrons introduced into the active layer 129 from the n-type contact layer 126 may be uniformly spread within the n-type contact layer 126 before passing through the low-doped n-GaN layer 127d.

Meanwhile, the p-type clad layer 131, which serves as an electron blocking layer, may be made of AlGaN and be formed in a multi-layer film structure. For example, the p-type clad layer 131 may be made of a multi-layer film of AlGaN/GaN or AlGaN/InGaN. When the p-type clad layer 131 is made of a multi-layer film, it may improve crystallinity of the AlGaN layer. For example, a layer of the p-type clad layer 131, adjacent to the active region 129, may be made of AlGaN, and the Al composition of the AlGaN layer may be gradually lowered toward the p-type contact layer 133. This is to reduce a polarization phenomenon due to the interface between the p-type clad layer 131 and the p-type contact layer 133. In addition, the first AlGaN layer, adjacent to the active region 129, may preferably be thinner than other layers in the p-type clad layer 131. It is preferable that the polarization phenomenon generated at an interface between the first AlGaN layer of the p-type clad layer 131 and the active region 129 reinforces the electron blocking, without having an effect on the active region 129 including In in consideration of the growth temperature (about 930°C, 20%) of the AlGaN. Meanwhile, the AlGaN layer of the p-type clad layer 131 may preferably have a higher energy level than that of the n-AlGaN layer 127b. In other words, in terms of the Al composition, the AlGaN layer of the p-type clad layer 131 is set to be higher than the n-AlGaN layer 127b. As the Al composition of the AlGaN layer of the p-type clad layer 131 is set to be higher than that of the n-AlGaN layer 127b, a conduction band at an n side may be higher than a conduction band at a p side based on the active layer at the time of applying forward voltage. As a result, this should be reduced.

In addition, an InAlN layer may further be included between the active region 129 and the p-type clad layer 131. In this case, in the InAlN layer In composition may be in a range of about 0.10 to 0.20, preferably, in a range of about 0.17 to 0.18. In this case, the growth temperature of the InAlN layer may, for example, be 845°C and have a superlattice layer of InN/AlN. In addition, the InAlN layer may have a thickness of about 10 to 30 nm, preferably about 18 to 22 nm. The InAlN layer may be formed to have a thinner thickness of the AlGaN layer forming the p-type clad layer 131. For example, the InAlN layer may be formed to have a thinner thickness of about 3:2 as compared to the AlGaN layer forming the p-type clad layer 131. The InAlN layer has the doping concentration of the p-type impurities of about 8 x 10¹⁷/cm³. At the time of doping the p-type impurities, InN may be preferably doped with the p-type impurities in the superlattice structure of InN/Aln. In this case, the InAlN layer may serve to increase hole concentration. The InAlN layer formed between the active region 129 and the p-type clad layer 131 may reduce effects of the temperature on the active region 129 when growing the p-type clad layer 131 functioning as the electron blocking layer.

In the exemplary embodiments of the present invention, the stacked number doped with n-type impurities of the spacer layer 128, the doping concentration of n-type impurities, the stacked thickness, the stacking times, the intermediate layer 127, the undoped layer, the thickness of the n-type clad layer may be related to each other and be controlled, as needed.

As set forth above, the present invention can improve the leakage current characteristics and the electrostatic discharge characteristics by doping the final layer with the high-concentration silicon without intentionally doping most regions in the superlattice layer disposed near the active region with impurities. In addition, the present invention interposes the undoped intermediate layer and the electron reinforcing layer between the superlattice layer and the n-type contact layer, thereby making it possible to spread current and prevent the increase in forward voltage.

Further, after the electron reinforcing layer is grown, the present invention maintains the grown electron reinforcing layer at the growth temperature of the electron reinforcing layer for a predetermined time, thereby making it possible to improve the crystal quality of the electron reinforcing layer. In addition, the present invention grows the active layer and then, stops the supply of metal source gas to relatively extend the time of increasing a substrate temperature at a temperature suitable to grow the p-side gallium nitride-based semiconductor layer, thereby making it possible to lower the leakage current.

Further, the present invention inserts the n-type AlGaN layer between the n-type GaN layers to prevent the thread dislocations generated from the low-temperature buffer layer from being transferred to the active region, thereby making it possible to lower the leakage current and improve the electrostatic discharge characteristics.

Further, the present invention improves the crystal quality of the active region, thereby making it possible to increase the recombination rate of the carriers within the active region. In addition, the present invention forms the spacer layer formed of the plurality of layers between the contact layer and the active region, thereby making it possible to reduce the strain generated in the active region. Further, the present invention can lower the driving voltage in the active region through the spacer layer by selectively doping only the layer adjacent to the active region with the n-type impurity. In addition, the present invention increases the role of the electron blocking layer, thereby making it possible to increase the recombination rate of the carriers in the active region.
temperature (about 930, 20%) of the AlGaN. Meanwhile, the AlGaN layer of the p-type clad layer 131 may preferably have a higher energy level than that of the n-AlGaN layer 127b. In other words, in terms of the Al composition, the AlGaN layer of the p-type clad layer 131 is set to be higher than the n-AlGaN layer 127b. As the Al composition of the AlGaN layer of the p-type clad layer 131 is set to be higher than that of the n-AlGaN layer 127b, a conduction band at an n side may be higher than a conduction band at a p side based on the active layer at the time of applying forward voltage. As a result, this should be reduced.

In addition, an InAlN layer may further be included between the active region 129 and the p-type clad layer 131. In this case, in the InAlN layer In composition may be in a range of about 0.10 to 0.20, preferably, in a range of about 0.17 to 0.18. In this case, the growth temperature of the InAlN layer may, for example, be 845 and have a superlattice layer of InN/AlN. In addition, the InAlN layer may have a thickness of about 10 to 30 nm, preferably about 18 to 22 nm. The InAlN layer may be formed to have a thinner thickness of the AlGaN layer forming the p-type clad layer 131. For example, the InAlN layer may be formed to have a thinner thickness of about 3:2 as compared to the AlGaN layer forming the p-type clad layer 131. The InAlN layer has the doping concentration of the p-type impurities of about 8 x 10¹⁷/ . At the time of doping the p-type impurities, InN may be preferably doped with the p-type impurities in the superlattice structure of InN/Aln. In this case, the InAlN layer may serve to increase hole concentration. The InAlN layer formed between the active region 129 and the p-type clad layer 131 may reduce effects of the temperature on the active region 129 when growing the p-type clad layer 131 functioning as the electron blocking layer.

In the exemplary embodiments of the present invention, the stacked number doped with n-type impurities of the spacer layer 128, the doping concentration of n-type impurities, the stacked thickness, the stacking times, the intermediate layer 127, the undoped layer, the thickness of the n-type clad layer may be related to each other and be controlled, as needed.

As set forth above, the present invention can improve the leakage current characteristics and the electrostatic discharge characteristics by doping the final layer with the high-concentration silicon without intentionally doping most regions in the superlattice layer disposed near the active region with impurities. In addition, the present invention interposes the undoped intermediate layer and the electron reinforcing layer between the superlattice layer and the n-type contact layer, thereby making it possible to spread current and prevent the increase in forward voltage.

Further, after the electron reinforcing layer is grown, the present invention maintains the grown electron reinforcing layer at the growth temperature of the electron reinforcing layer for a predetermined time, thereby making it possible to improve the crystal quality of the electron reinforcing layer. In addition, the present invention grows the active layer and then, stops the supply of metal source gas to relatively extend the time of increasing a substrate temperature at a temperature suitable to grow the p-side gallium nitride-based semiconductor layer, thereby making it possible to lower the leakage current.

Further, the present invention inserts the n-type AlGaN layer between the n-type GaN layers to prevent the thread dislocations generated from the low-temperature buffer layer from being transferred to the active region, thereby making it possible to lower the leakage current and improve the electrostatic discharge characteristics.

Further, the present invention improves the crystal quality of the active region, thereby making it possible to increase the recombination rate of the carriers within the active region. In addition, the present invention forms the spacer layer formed of the plurality of layers between the contact layer and the active region, thereby making it possible to reduce the strain generated in the active region. Further, the present invention can lower the driving voltage in the active region through the spacer layer by selectively doping only the layer adjacent to the active region with the n-type impurity. In addition, the present invention increases the role of the electron blocking layer, thereby making it possible to increase the recombination rate of the carriers in the active region.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A light emitting diode, comprising:
an n-type contact layer (126);
a p-type contact layer (133) formed on the n-type contact layer (126);
an active region (129) having a multi-quantum well structure including an InGaN quantum well layer and interposed between the n-type contact layer (126) and the p-type contact layer (133); and
a spacer layer (128) interposed between the n-type contact layer (126) and the active region (129),
wherein the spacer layer (128) is doped with n-type impurities, and the n-type impurity doping concentration is relatively higher than the impurity doping concentration of the n-type contact layer (126), and the active region (129) is undoped with the n-type impurities,
wherein the spacer layer (128) includes an InGaN layer,
wherein the content of In of the spacer layer (128) is lower than that within the quantum well layer;
**characterized in that**
it further comprises an intermediate layer (127) formed between the spacer layer (128) and the n-type contact layer (126),
wherein the intermediate layer (127) includes a layer doped with the n-type impurities at a concentration relatively higher than the impurity doping concentration of the n-type contact layer (126) and relatively lower than the n-type impurity doping concentration of the spacer layer (128);
the intermediate layer includes an n-type AlGaN layer; and the n-type AlGaN layer has a gradually or stepwise reduced Al composition toward the active region (129).

2. The light emitting diode of claim 1, wherein the spacer layer (128) is formed by alternately stacking InₓGa₁₋ₓ N (0≤x<1) and In_{y}Ga_{1-y}N (0≤y<1).

3. The light emitting diode of claim 1, wherein the spacer layer (128) includes mutually alternately stacked superlattice layers.

4. The light emitting diode of claim 1, wherein the spacer layer (128) is configured of a plurality of layers (128a-c), at least one layer adjacent to the active region of the plurality of layers being doped with n-type impurities, remaining layers thereof being undoped with the n-type impurities, and the n-type impurity doping concentration being relatively higher than the impurity doping concentration of the n-type contact layer (126).

5. The light emitting diode of claim 1, wherein the n-type AlGaN layer is formed in a multi-layer film structure of AlGaN/GaN or AlGaN/InGaN.

6. The light emitting diode of claim 1, wherein the intermediate layer (127) further includes an n-GaN layer (127a) between the spacer layer (128) and the n-type AlGaN layer (127b).

7. The light emitting diode of claim 1, wherein the intermediate layer (127) includes at least one of an undoped GaN layer (127c) and a low-doped n-GaN layer (127d) between the n-type AlGaN layer (127b) and the n-type contact layer (126).

8. The light emitting diode of claim 1, further comprising a p-type clad layer (131) formed between the active region (129) and the p-type contact layer (133).

## Patentansprüche

1. Leuchtdiode, die Folgendes umfasst:
eine Kontaktschicht vom n-Typ (126);
eine Kontaktschicht vom p-Typ (133), die auf der Kontaktschicht vom n-Typ (126) ausgebildet ist;
eine aktive Region (129), die eine Mehrquantenmuldenstruktur aufweist, die eine InGaN-Quantenmuldenschicht umfasst und zwischen der Kontaktschicht vom n-Typ (126) und der Kontaktschicht vom p-Typ (133) angeordnet ist;
und
eine Abstandshalterschicht (128), die zwischen der Kontaktschicht vom n-Typ (126) und der aktiven Region (129) angeordnet ist,
wobei die Abstandshalterschicht (128) mit Störatomen vom n-Typ dotiert ist und die Konzentration der Dotierung mit Störatomen vom n-Typ relativ höher ist als die Konzentration der Dotierung mit Störatomen der Kontaktschicht vom n-Typ (126) und die aktive Region (129) frei von einer Dotierung mit Störatomen vom n-Typ ist,
wobei die Abstandshalterschicht (128) eine InGaN-Schicht umfasst,
wobei der Gehalt an In der Abstandshalterschicht (128) geringer ist als der in der Quantenmuldenschicht;
**dadurch gekennzeichnet, dass** sie des Weiteren eine Zwischenschicht (127) umfasst, die zwischen der Abstandshalterschicht (128) und der Kontaktschicht vom n-Typ (126) ausgebildet ist,
wobei die Zwischenschicht (127) eine Schicht umfasst, die mit den Störatomen vom n-Typ in einer Konzentration dotiert ist, die relativ höher ist als die Konzentration der Dotierung mit Störatomen der Kontaktschicht vom n-Typ (126) und relativ niedriger ist als die Konzentration der Dotierung mit Störatomen vom n-Typ der Abstandshalterschicht (128);
die Zwischenschicht eine AlGaN-Schicht vom n-Typ umfasst;
und
die AlGaN-Schicht vom n-Typ eine allmählich oder schrittweise verringerte Al-Zusammensetzung in Richtung der aktiven Region (129) aufweist.

2. Leuchtdiode nach Anspruch 1, wobei die Abstandshalterschicht (128) durch abwechselndes Übereinanderlegen von InₓGa₁₋ₓN (0≤x<1) und In_{y}Ga_{1-y}N (0≤y<1) gebildet wird

3. Leuchtdiode nach Anspruch 1, wobei die Abstandshalterschicht (128) abwechselnd übereinandergelegte Supergitterschichten umfasst.

4. Leuchtdiode nach Anspruch 1, wobei die Abstandshalterschicht (128) aus mehreren Schichten (128a-c) ausgebildet ist, wobei mindestens eine Schicht neben der aktiven Region der mehreren Schichten mit Störatomen vom n-Typ ist, wobei die übrigen Schichten nicht mit den Störatomen vom n-Typ sind, und die Konzentration der Dotierung mit Störatomen vom n-Typ relativ höher ist als die Konzentration der Dotierung mit Störatomen der Kontaktschicht vom n-Typ (126).

5. Leuchtdiode nach Anspruch 1, wobei die AIGaN-Schicht vom n-Typ in einer Mehrschichtfilmstruktur aus AlGaN/GaN oder AlGaN/InGaN ausgebildet ist.

6. Leuchtdiode nach Anspruch 1, wobei die Zwischenschicht (127) des Weiteren eine n-GaN-Schicht (127a) zwischen der Abstandshalterschicht (128) und der AlGaN-Schicht vom n-Typ (127b) umfasst.

7. Leuchtdiode nach Anspruch 1, wobei die Zwischenschicht (127) eine undotierte GaN-Schicht (127c) und/oder eine schwach-dotierte n-GaN-Schicht (I 27d) zwischen der AlGaN-Schicht vom n-Typ (127b) und der Kontaktschicht vom n-Typ (126) umfasst.

8. Leuchtdiode nach Anspruch 1, die des Weiteren eine Plattierungsschicht vom p-Typ (131) umfasst, die zwischen der aktiven Region (129) und der Kontaktschicht vom p-Typ (133) ausgebildet ist.

## Revendications

1. Diode électroluminescente comprenant :
une couche de contact du type N (126) ;
une couche de contact du type P (133) formée sur la couche de contact du type N (126) ;
une région active (129) possédant une structure à puits quantique multiple comportant une couche à puits quantique d'InGaN et étant intercalée entre la couche de contact du type N (126) et la couche de contact du type P (133) ; et
une couche intercalaire (128) intercalée entre la couche de contact du type N (126) et la région active (129),
dans laquelle la couche intercalaire (128) est dopée par des impuretés du type N, et la concentration de dopage par des impuretés du type N est relativement supérieure à la concentration de dopage par des impuretés de la couche du type N (126), et la région active (129) est non dopée par les impuretés du type N,
dans laquelle la couche intercalaire (128) comporte une couche d'InGaN,
dans laquelle la teneur en In de la couche intercalaire (128) est inférieure à celle de la couche à puits quantique ;
**caractérisée en ce que** :
elle comprend en outre une couche intermédiaire (127) formée entre la couche intercalaire (128) et la couche de contact du type N (126),
dans laquelle la couche intermédiaire (127) comporte une couche dopée par les impuretés du type N selon une concentration relativement supérieure à la concentration de dopage par des impuretés de la couche de contact du type N (126) et relativement inférieure à la concentration de dopage par des impuretés du type N de la couche intercalaire (128) ;
la couche intermédiaire comporte une couche d'AlGaN du type N ; et
la teneur en Al de la couche d'AlGaN du type N diminue progressivement ou par paliers en direction de la région active (129).

2. Diode électroluminescente selon la revendication 1, dans laquelle la couche intercalaire (128) est formée par empilement alterné d'InₓGa₁₋ₓN (0 ≤ x < 1) et d'In_{y}Ga_{1-y}N (0 ≤ y < 1).

3. Diode électroluminescente selon la revendication 1, dans laquelle la couche intercalaire (128) comporte des couches de super-réseau empilées en alternance les unes sur les autres.

4. Diode électroluminescente selon la revendication 1, dans laquelle la couche intercalaire (128) est constituée d'une pluralité de couches (128a à 128c), au moins une couche voisine de la région active de la pluralité de couches étant dopée par des impuretés du type N, ses couches restantes étant non dopées par les impuretés du type N, et la concentration de dopage par des impuretés du type N étant relativement supérieure à la concentration de dopage par des impuretés de la couche de contact du type N (126).

5. Diode électroluminescente selon la revendication 1, dans laquelle la couche d'AlGaN du type N est formée en une structure de film multicouche d'AlGaN/GaN ou d'AlGaN/InGaN.

6. Diode électroluminescente selon la revendication 1, dans laquelle la couche intermédiaire (127) comporte en outre une couche de n-GaN (127a) entre la couche intercalaire (128) et la couche d'AlGaN du type N (127b).

7. Diode électroluminescente selon la revendication 1, dans laquelle la couche intermédiaire (127) comporte au moins une couche de GaN non dopée (127c) et une couche de n-GaN faiblement dopée (127d) entre la couche d'AlGaN du type N (127b) et la couche de contact du type N (126).

8. Diode électroluminescente selon la revendication 1, comprenant en outre une couche de placage du type P (131) formée entre la région active (129) et la couche de contact du type P (133).
